# EUROPÄISCHE PATENTSCHRIFT

(11) **EP 3 215 391 B1**
(45) Veröffentlichungstag und Bekanntmachung des Hinweises auf die Patenterteilung: **20.01.2021**
(21) Anmeldenummer: 15775087.8
(22) Anmeldetag: 06.10.2015
(51) Int. Cl.: B60K 37/06, G06F 1/16

(54) **ANZEIGEVORRICHTUNG FÜR EINEN KRAFTWAGEN, VERFAHREN ZUM BETREIBEN EINER ANZEIGEVORRICHTUNG UND KRAFTWAGEN MIT EINER ANZEIGEVORRICHTUNG**
DISPLAY DEVICE FOR A MOTOR VEHICLE, METHOD FOR OPERATING A DISPLAY DEVICE, AND MOTOR VEHICLE HAVING A DISPLAY DEVICE
SYSTÈME D'AFFICHAGE POUR VÉHICULE AUTOMOBILE, PROCÉDÉ POUR FAIRE FONCTIONNER UN SYSTÈME D'AFFICHAGE ET VÉHICULE AUTOMOBILE ÉQUIPÉ D'UN SYSTÈME D'AFFICHAGE

(30) Priorität: 03.11.2014 DE 102014016323
(43) Veröffentlichungstag der Anmeldung: 13.09.2017
(73) Patentinhaber: Audi AG, 85045 Ingolstadt (DE)
(72) Erfinder: HÉLOT, Jacques, 85051 Ingolstadt (DE); WEIGELT, Sandro, 85101 Lenting (DE); REDEKER, Immo, 85049 Ingolstadt (DE); HACKENBERG, Ulrich, 85139 Wettstetten (DE); MAYER, Roland, 85101 Lenting (DE)
(86) Internationale Anmeldenummer: PCT/EP2015/001948
(87) Internationale Veröffentlichungsnummer: WO 2016/070951

(56) Entgegenhaltungen:
- EP-A1- 2 421 231
- EP-A2- 1 245 429
- US-A1- 2014 099 479

## Beschreibung

Die Erfindung betrifft eine Anzeigevorrichtung für einen Kraftwagen der im Oberbegriff von Patentanspruch 1 angegebenen Art. Sie betrifft überdies ein Verfahren zum Betreiben einer Anzeigevorrichtung. Des Weiteren betrifft die Erfindung einen Kraftwagen mit einer derartigen Anzeigevorrichtung.

In immer mehr Kraftwagen werden beispielsweise in der Instrumententafel oder auch in der Mittelkonsole Displays, insbesondere auch Touchscreens, angeordnet. Insbesondere um Touchscreens optimal bedienbar zu gestalten, müssen Bedienfelder einer graphischen Benutzeroberfläche an die Fingergröße angepasst werden. Dies führt häufig zu relativ großen Displays, insbesondere wenn graphische Benutzeroberflächen mit vielen Bedienelementen angezeigt werden müssen. Dies führt wiederum zu entsprechend groß ausgebildeten Aufnahmebereichen innerhalb von Kraftwagen, beispielsweise im Bereich von Mittelkonsolen und Schalttafeln.

Zudem besteht bei einer Bedienung solcher Touchscreens auch teilweise das Problem, dass insbesondere ein Fahrer eine Vielzahl von Eingaben tätigen muss, bis er innerhalb einer Menüstruktur des Touchscreens seine wunschgemäße Bedienoberfläche vorfindet. Dies birgt das Risiko, dass er vom Fahrgeschehen abgelenkt wird.

Für den Fall, dass derartige Displays gerade nicht verwendet werden, ist es allgemein bekannt, diese Displays ein- und ausfahrbar zu gestalten. Dies ist jedoch relativ kostenintensiv und erfordert eine relativ robuste Konstruktion, vor allem wenn eine Touch-Bedienung mit einem oftmaligen Berühren derartiger Displays vorgesehen ist. Des Weiteren ist es für eine optimale ergonomische Bedienung eines Touchscreens notwendig, eine Auflagefläche für die Hand oder den Arm bereitzustellen. Üblicherweise ist allerdings der Abstand zwischen einer entsprechenden Auflagefläche und einem dieser Auflagefläche zugeordneten Display nicht konstant. Dadurch müssen Fahrzeuginsassen bei der Bedienung nicht nur ihre Finger sondern meistens auch die gesamte Hand bewegen.

Die DE 101 15 050 A1 zeigt eine Anzeigevorrichtung für einen Kraftwagen, welche eine flexible Anzeigeeinrichtung und eine Verstelleinrichtung aufweist, wobei die Verstelleinrichtung dazu ausgebildet ist, die Anzeigeeinrichtung von einer Verstauposition in eine Gebrauchsposition zu bewegen. Die Verstelleinrichtung umfasst dabei ein Antriebszahnrad, mittels welchem die flexible Anzeigeeinrichtung von einer in einem Aufnahmebereich angeordneten, nicht sichtbaren Verstauposition in die für einen Fahrzeuginsassen sichtbare Gebrauchsposition rolloartig ausgefahren werden kann. Diese Druckschrift wurde zur Formulierung des Oberbegriffs von Patentanspruch 1 herangezogen.

Die WO 2011/062583 A1 zeigt ein rolloartig ausgebildetes flexibles Display, welches ebenfalls von einer Verstauposition in eine Gebrauchsposition bewegt werden kann.

Die KR 20130117110 A zeigt ein gekrümmtes Display, wobei die Krümmung des Displays situationsabhängig angepasst werden kann. In Abhängigkeit von jeweiligen Positionen von Betrachtern, welche auf das Display blicken, wird die Krümmung des Displays derart angepasst, dass sämtliche Personen mit einem besonders günstigen Blickwinkel auf das Display schauen können.

Die EP 2 421 231 A zeigt ein mobiles Endgerät, bei dem es sich um einen MP3-Player oder um ein Smartphone handeln kann. Das mobile Endgerät weist zwei Gehäusehälften auf, die über ein Scharnier miteinander verbunden sind. Dadurch können die Gehäusehälften manuell von einem Benutzer zusammengeklappt und aufgeklappt werden. Außenseitig an den Gehäusehälften ist ein flexibles Display angebracht.

Die US 2014/0099479 A1 zeigt ebenfalls ein mobiles Endgerät mit einem flexiblen Display. Das Display kann wie eine Art Rollo an seinen Außenenden aufgerollt werden. Die aufgerollten Enden werden mittels jeweiliger Gehäuseteile aufgenommen.

Es ist die Aufgabe der vorliegenden Erfindung, eine verbesserte Lösung bereitzustellen, mittels welcher eine Anzeigeeinrichtung von einer Verstauposition in eine Gebrauchsposition bewegt werden kann.

Diese Aufgabe wird durch eine Anzeigevorrichtung für einen Kraftwagen, durch ein Verfahren zum Betrieben einer Anzeigevorrichtung sowie durch einen Kraftwagen mit einer Anzeigevorrichtung mit den Merkmalen der unabhängigen Patentansprüche gelöst. Vorteilhafte Ausgestaltungen mit zweckmäßigen und nicht trivialen Weiterbildungen der Erfindung sind in den abhängigen Ansprüchen angegeben.

Die erfindungsgemäße Anzeigevorrichtung für einen Kraftwagen umfasst eine flexible Anzeigeeinrichtung und eine Verstelleinrichtung, welche dazu ausgebildet ist, die Anzeigeeinrichtung von einer Verstauposition in eine Gebrauchsposition zu bewegen. Die erfindungsgemäße Anzeigevorrichtung zeichnet sich dabei dadurch aus, dass die Verstelleinrichtung dazu ausgebildet ist, die Anzeigeeinrichtung von der Verstauposition in die Gebrauchsposition zu biegen. Des Weiteren kann die Anzeigeeinrichtung mittels der Verstelleinrichtung wiederum auch von der Gebrauchsposition zurück in die Verstauposition gebogen werden.

Vorzugsweise umfasst die Verstelleinrichtung einen verschwenkbaren Hebelmechanismus, welcher dazu ausgebildet ist, die Anzeigeeinrichtung von der Verstauposition in die Gebrauchsposition zu biegen. Durch den verschwenkbaren Hebelmechanismus kann die Anzeigeeinrichtung besonders einfach von der Verstauposition in die Gebrauchsposition gebogen werden. Des Weiteren kann mit dem verschwenkbaren Hebelmechanismus die Anzeigeeinrichtung wiederum auch von der Gebrauchsposition zurück in die Verstauposition gebogen werden.

Die Anzeigevorrichtung umfasst vorzugsweise eine in einem Bauteil ausgebildete Vertiefung, in welcher die Anzeigeeinrichtung in der Verstauposition eben angeordnet ist. Beispielsweise kann die Anzeigeeinrichtung bündig mit dem betreffenden Bauteil abschließen, wenn die Anzeigeeinrichtung in der Verstauposition angeordnet ist. In der Gebrauchsposition ist zumindest ein Teil der Anzeigeeinrichtung aus der Vertiefung herausgebogen. Mit anderen Worten ist die Anzeigeeinrichtung in der Gebrauchsposition von dem betreffenden Bauteil weggebogen.

Mittels der erfindungsgemäßen Anzeigevorrichtung wird also die flexible Anzeigeeinrichtung nicht mehr mechanisch ein- und ausgefahren. Stattdessen kann die flexible Anzeigeeinrichtung mittels der Verstelleinrichtung, insbesondere mittels des verschwenkbaren Hebelmechanismus, auf einfache Weise in die Gebrauchsposition nach oben gebogen werden, falls die flexible Anzeigeeinrichtung von einem Fahrzeuginsassen bedient werden soll.

Eine Sichtseite der Anzeigeeinrichtung oder zumindest ein Teil der Sichtseite, auf welcher für einen Fahrzeuginsassen unterschiedliche Inhalte angezeigt werden können, ist dabei vorzugsweise in der Gebrauchsposition konkav gewölbt. Mit anderen Worten ist in der Gebrauchsposition eine von einem Fahrzeuginsassen abgewandte Rückseite der Anzeigeeinrichtung konvex und eine dem Fahrzeuginsassen zugewandte Vorderseite der Anzeigeeinrichtung konkav ausgebildet. Ein Abstand zwischen einer Auflagefläche einer Hand eines Fahrzeuginsassen und der Anzeigeeinrichtung kann zudem durch die erfindungsgemäße Anzeigevorrichtung im Wesentlichen konstant gestaltet werden, ganz im Gegensatz zu einem mechanisch ein- und ausfahrbaren Display. Insbesondere durch die vorzugsweise konkave Wölbung der Vorderseite bzw. der Sichtseite der Anzeigeeinrichtung in der Gebrauchsposition kann der Abstand zwischen einer Auflagefläche einer Hand eines Fahrzeuginsassen und der Anzeigeeinrichtung im Wesentlichen konstant gestaltet sein. Dadurch verbessert sich insbesondere auch die Ergonomie bei der Bedienung der flexiblen Anzeigeeinrichtung. Der Abstand zwischen der flexiblen Anzeigeeinrichtung und einer Hand eines Fahrzeuginsassen bzw. zwischen Fingern des Fahrzeuginsassen und der Anzeigeeinrichtung kann auch vorzugsweise einstellbar sein, so dass Fahrzeuginsassen mit unterschiedlich großen Händen die flexible Anzeigeeinrichtung besonders ergonomisch bedienen können. Beispielsweise kann der Neigungswinkel, gemäß welchem die flexible Anzeigeeinrichtung mittels der Verstelleinrichtung in die Gebrauchsposition gebogen wird, manuell einstellbar oder mittels Sensoren automatisch regelbar ausgestaltet sein.

In vorteilhafter Ausgestaltung der Erfindung ist es vorgesehen, dass der Hebelmechanismus zumindest einen Hebel aufweist, welcher mit einem Endbereich an einem von der Anzeigeeinrichtung verschiedenen Bauteil der Anzeigevorrichtung verschwenkbar gelagert und mit einem gegenüberliegenden Endbereich an einer an der Anzeigeeinrichtung befestigten Linearführung gelagert ist. Dadurch kann die flexible Anzeigeeinrichtung auf besonders einfache und zuverlässige Weise zwischen der Verstauposition und der Gebrauchsposition hin und her gebogen werden. Mittels der Linearführung wird eine besonders exakte Führung des Hebels entlang der Anzeigeeinrichtung ermöglicht. Dadurch kann die Anzeigeeinrichtung besonders exakt und zuverlässig von der Verstauposition in die Gebrauchsposition und auch wieder zurück in die Verstauposition gebogen werden.

Gemäß einer alternativen vorteilhaften Ausführungsform der Anzeigevorrichtung ist es vorgesehen, dass der Hebelmechanismus zwei Hebel aufweist, welche mit jeweiligen Endbereichen an zumindest einem von der Anzeigeeinrichtung verschiedenen Bauteil der Anzeigevorrichtung verschwenkbar gelagert und mit jeweiligen gegenüberliegenden Endbereichen an jeweiligen an der Anzeigeeinrichtung befestigen Linearführungen gelagert sind. Bei einer bestimmungsgemäßen Anordnung der Anzeigevorrichtung in einem Kraftwagen wird dadurch die Möglichkeit bereitgestellt, die flexible Anzeigeeinrichtung nicht nur in Fahrzeughochrichtung nach oben zu biegen. Aufgrund der beiden Hebel ist es zudem möglich, die flexible Anzeigeeinrichtung in Richtung eines Fahrers oder eines Beifahrers - also in Fahrzeugquerrichtung - zu neigen, so dass die jeweiligen Fahrzeuginsassen die flexible Anzeigeeinrichtung besonders ergonomisch einsehen und bedienen können. Beispielsweise kann die Anzeigevorrichtung eine entsprechende Sensorik aufweisen, welche dazu ausgebildet ist, zu erfassen, ob gerade ein Fahrer oder ein Beifahrer die flexible Anzeigeeinrichtung bedienen möchte, wobei in Abhängigkeit davon die Verstelleinrichtung derart angesteuert wird, dass die beiden Hebel derart betätigt bzw. bewegt werden, dass die flexible Anzeigeeinrichtung beispielsweise in Richtung eines Fahrers oder eines Beifahrers geneigt wird. Es können somit unterschiedliche Gebrauchspositionen eingestellt werden, wobei es um eine fahrerorientierte und um eine beifahrerorientierte Gebrauchsposition handeln kann.

Erfindungsgemäß ist es vorgesehen, dass die Anzeigeeinrichtung mehrere übereinander angeordnete Schichten aufweist, wobei ausschließlich die obere Schicht in einem ersten Endbereich der Anzeigeeinrichtung an einem von der Anzeigeeinrichtung verschiedenen Bauteil befestigt ist und die Schichten der Anzeigeeinrichtung an einem gegenüberliegend von dem ersten Endbereich angeordneten freien Endbereich der Anzeigeeinrichtung mittels einer Klemmeinrichtung miteinander verbunden sind. Eine oder mehrere unter der oberen Schicht angeordnete Schichten können sich also beim Aufbiegen der Anzeigeeinrichtung von der Verstauposition in die Gebrauchsposition translatorisch bezüglich der oberen Schicht bewegen. Beim Aufbiegen der flexiblen Anzeigeeinrichtung werden die untereinander angeordneten Schichten nämlich unterschiedlich stark gebogen, wobei aufgrund der Relativbeweglichkeit der Schichten zueinander diese sich beim Aufbiegen der Anzeigeeinrichtung in die Gebrauchsposition relativ zueinander verschieben können. Durch diesen Freiheitsgrad können unerwünschte und gegebenenfalls schädliche Spannungen innerhalb der einzelnen Schichten vermieden werden, infolgedessen sonst gegebenenfalls wellenförmige Unebenheiten in den Schichten auftreten würden. Durch die translatorischen Relativbewegungen kann es vorkommen, dass sich die einzelnen Schichten elektrostatisch aufladen. Infolgedessen kann es passieren, dass sich die Schichten gegenseitig lokal anziehen, was zu einer unerwünschten Ausbildung von Beulen führen kann. Dies wirkt sich unter anderem negativ auf das optische Erscheinungsbild aus. Vorzugsweise wird deswegen an denjenigen Schichten, die sich translatorisch relativ zueinander bewegen können, eine antistatische Beschichtung angebracht.

In weiterer vorteilhafter Ausgestaltung der Erfindung ist es vorgesehen, dass die obere Schicht eine transparente Deckschicht ist, unter welcher eine organische Leuchtdioden aufweisende Anzeigeschicht angeordnet ist. Durch die transparente Deckschicht wird die darunterliegende Anzeigeschicht vor Umwelteinflüssen geschützt. Bei der Anzeigeschicht handelt es sich also vorzugsweise um eine OLED-Schicht. Derartige OLED-Schichten können im aktiven Zustand wie eine Kunststofffolie gebogen werden. Allgemein kann es sich bei der Anzeigeinrichtung also um ein OLED-Display handeln. Die transparente Deckschicht ist dabei ebenfalls flexibel ausgebildet und kann beispielsweise aus einem Plexiglas oder einem biegsamen Glas hergestellt sein. Beispielsweise kann die Deckschicht aus einem dünnen, chemisch vorgespannten Glas aus der Gruppe der Alumosilikatgläser hergestellt sein. Ein derartiges Glas ist unter dem Markennamen Gorilla Glas bekannt. Die Deckschicht kann auch teiltransparent ausgebildet sein und eine Tönung aufweisen. Mittels der Tönung kann eine Haftvermittlerschicht, auch Primerschicht genannt, welche unterhalb von der Deckschicht angebracht ist, optisch kaschiert werden. Vorzugsweise weist die Deckschicht eine Anti-Reflexionsoberfläche bzw. einer entsprechende Anti-Reflexionsbeschichtung auf. Dies trägt dazu bei, dass die Anzeigeeinrichtung auch im gebogenen Zustand besonders gut ablesbar ist.

In weiterer vorteilhafter Ausgestaltung der Erfindung ist es vorgesehen, dass die obere Schicht eine transparente Deckschicht ist, unter welcher eine transparente berührungssensitive Sensorschicht und eine organische Leuchtdioden aufweisende Anzeigeschicht angeordnet ist. Bei der Anzeigeeinrichtung kann es sich allgemein um einen Touchscreen handeln, unabhängig davon, ob die Anzeigeschicht organische Leuchtdioden aufweist oder einen anderen Aufbau aufweist. Mit anderen Worten handelt es sich bei der Anzeigeeinrichtung vorzugsweise um einen Touchscreen, wobei mittels der berührungssensitiven Sensorschicht, welche ebenfalls flexibel ausgebildet ist, Berührungen an der Anzeigeeinrichtung erfasst und in entsprechende Steuersignale umgesetzt werden können. Die transparente Deckschicht dient auch bei dieser bevorzugten Ausführungsform als Schutzschicht, mittels welcher die berührungssensitive Sensorschicht und die organische Leuchtdioden aufweisende Anzeigeschicht im Betrieb vor Umwelteinflüssen geschützt werden.

Eine weitere vorteilhafte Ausführungsform der Erfindung sieht vor, dass unter der Anzeigeschicht eine Trägerschicht angeordnet ist, welche eine in Richtung der Deckschicht gerichtete Kraft auf die Anzeigeschicht ausübt und bezüglich des ersten Endes zumindest relativbeweglich zu der Deckschicht ist. Die Trägerschicht kann zum Beispiel als eine Art Federelement, beispielsweise in Form einer Blattfeder oder dergleichen, ausgebildet sein. Mittels der Trägerschicht werden also die anderen Schichten an die Deckschicht gedrückt, so dass die einzelnen Schichten durchgehend miteinander in Berührung bleiben. Mit anderen Worten wird mittels der Trägerschicht der Zusammenhalt der einzelnen Schichten der Anzeigeeinrichtung sichergestellt.

In weiterer vorteilhafter Ausgestaltung der Erfindung ist es vorgesehen, dass die Anzeigevorrichtung eine Abdeckung aufweist, welche in der Gebrauchsposition der Anzeigeeinrichtung eine Öffnung verdeckt, die durch Verschwenken der Anzeigeeinrichtung von der Verstauposition in die Gebrauchsposition entsteht. Zum einen kann das Eindringen von Schmutz in die Öffnung dadurch verhindert werden und zum anderen wird die optische Erscheinung der gesamten Anzeigevorrichtung durch die Abdeckung verbessert. Insbesondere kann durch die Abdeckung verhindert werden, dass kleinere Gegenstände, wie beispielsweise Schlüssel, Papierstücke oder Essensreste und dergleichen, in die Öffnung gelangen.

Der erfindungsgemäße Kraftwagen umfasst die erfindungsgemäße Anzeigevorrichtung oder eine vorteilhafte Ausführungsform der erfindungsgemäßen Anzeigevorrichtung.

In vorteilhafter Ausgestaltung des Kraftwagens ist es vorgesehen, dass die Anzeigeeinrichtung an einem Mitteltunnel des Kraftwagens in Vorwärtsfahrtrichtung vor einem Gangwahlhebel des Kraftwagens angeordnet ist. Bei dem Gangwahlhebel kann es sich beispielsweise um einen sogenannten Shift-By-Wire-Hebel handeln, mittels welchem unterschiedliche Fahrstufen des Kraftwagens eingelegt werden können. Dadurch, dass die Anzeigeeinrichtung vor dem Gangwahlhebel angeordnet ist, kann ein Fahrzeuginsasse den Gangwahlhebel als Handablage verwenden, wodurch er die Anzeigeeinrichtung, insbesondere wenn es sich dabei um einen Touchscreen handelt, besonders bequem bedienen kann. Die Positionierung der Anzeigeeinrichtung ist dabei nicht auf den Mitteltunnel des Kraftwagens beschränkt. Stattdessen kann die Anzeigeeinrichtung im Wesentlichen an beliebigen Positionen des Kraftwagens angeordnet sein, beispielsweise in einer Instrumententafel oder auch in einem Rücksitzbereich des Kraftwagens. Im Rücksitzbereich kann die Anzeigeeinrichtung beispielsweise in einer in der zweiten Sitzreihe angeordneten Mittelkonsole angeordnet sein.

Bei dem erfindungsgemäßen Verfahren zum Betreiben einer Anzeigevorrichtung eines Kraftwagens wird eine flexible Anzeigeeinrichtung der Anzeigevorrichtung mittels einer Verstelleinrichtung der Anzeigevorrichtung von einer Verstauposition in eine Gebrauchsposition bewegt. Die Anzeigeeinrichtung weist mehrere übereinander angeordnete Schichten auf, wobei ausschließlich die obere Schicht in einem ersten Endbereich der Anzeigeeinrichtung an einem von der Anzeigeeinrichtung verschiedenen Bauteil befestigt ist und die Schichten der Anzeigeeinrichtung an einem gegenüberliegend von dem ersten Endbereich angeordneten freien Endbereich der Anzeigeeinrichtung mittels einer Klemmeinrichtung miteinander verbunden sind. Beim erfindungsgemäßen Verfahren wird die Anzeigeeinrichtung mittels der Verstelleinrichtung von der Verstauposition in die Gebrauchsposition gebogen, wobei sich eine oder mehrere unter der oberen Schicht angeordnete Schichten beim Aufbiegen der Anzeigeeinrichtung von der Verstauposition in die Gebrauchsposition translatorisch bezüglich der oberen Schicht bewegen. Vorteilhafte Ausgestaltungen der erfindungsgemäßen Anzeigevorrichtung sind dabei als vorteilhafte Ausgestaltungen des erfindungsgemäßen Verfahrens anzusehen, wobei die Anzeigevorrichtung insbesondere Mittel zur Durchführung der Verfahrensschritte aufweist.

In vorteilhafter Ausgestaltung des erfindungsgemäßen Verfahrens ist es vorgesehen, dass die Anzeigeeinrichtung von einer Verstauposition in die Gebrauchsposition gebogen wird, sobald eine Zündung des Kraftwagens aktiviert worden ist. Mit anderen Worten wird die Anzeigeeinrichtung automatisch von der Verstauposition in die Gebrauchsposition gebogen, sobald der Zustand Klemme 15 an vorliegt. Vorzugsweise wird die Anzeigevorrichtung zum Anzeigen von Inhalten auch erst aktiviert, wenn die Zündung des Kraftwagens aktiviert worden ist. Die Anzeigeeinrichtung wird also bei aktivierter Anzeige automatisch von der Verstauposition in die Gebrauchsposition hochgebogen, sobald eine Zündung des Kraftwagens aktiviert worden ist.

In weiterer vorteilhafter Ausgestaltung des erfindungsgemäßen Verfahrens ist es vorgesehen, dass die Anzeigeeinrichtung von der Gebrauchsposition in die Verstauposition gebogen wird, sobald eine Zündung des Kraftwagens deaktiviert worden ist. Mit anderen Worten wird die Anzeigeeinrichtung also wieder zurück in die Verstauposition gebogen, ohne dass ein Fahrzeuginsasse eine aktive Handlung an der Anzeigevorrichtung vornehmen muss. Zusätzlich kann es aber auch vorgesehen sein, dass die Anzeigevorrichtung ein Bedienelement aufweist, durch dessen Betätigung ein Hochbiegen der Anzeigeeinrichtung von der Verstauposition in die Gebrauchsposition und ein Herunterbiegen von der Gebrauchsposition in die Verstauposition bewirkt werden kann. Alternativ oder zusätzlich kann es auch vorgesehen sein, dass durch einen Doppel-Klick auf die in Ihrer Verstauposition angeordneten Anzeigeeinrichtung ein Verfahren der Anzeigeeinrichtung in die Gebrauchsposition bewirkt werden kann. In der Gebrauchsposition kann dann beispielsweise durch ein längeres Berühren der Anzeigeeinrichtung, z.B. mit fünf Fingern gleichzeitig, bewirkt werden, dass die Anzeigeeinrichtung wieder in ihre Verstauposition bewegt wird. Dadurch können Fahrzeuginsassen auch aktiv ein Heraufbiegen und ein Herunterbiegen der Anzeigeeinrichtung und vorzugsweise im Zusammenhang damit auch eine Aktivierung und Deaktivierung einer Anzeige der Anzeigeeinrichtung bewirken.

Schließlich ist es gemäß einer weiteren vorteilhaften Ausführungsform des erfindungsgemäßen Verfahrens vorgesehen, dass die Gebrauchsposition in Abhängigkeit von einer erfassten Personenerkennung vorgegeben wird. Mit anderen Worten wird die Neigung der Anzeigeeinrichtung, durch welche die Gebrauchsposition definiert wird, benutzerspezifisch vorgegeben. Beispielsweise kann erfasst werden, mit welchem Fahrzeugschlüssel der Kraftwagen entriegelt worden ist, wobei anhand einer Schlüsselkennung eine jeweilige Gebrauchsposition, also eine jeweils benutzerspezifische Neigung der Anzeigeeinrichtung in der Gebrauchsposition, vorgegeben wird. Alternativ oder zusätzlich kann es auch vorgesehen sein, dass ein mobiles Endgerät, insbesondere ein Smartphone, automatisch beim Einsteigen in den Kraftwagen mit diesem gekoppelt wird. Anhand des gekoppelten mobilen Endgeräts erfolgt die Personenerkennung. Dadurch findet beispielsweise ein Fahrer immer eine für ihn besonders bequeme Gebrauchsposition der Anzeigeeinrichtung vor, welche an die anatomischen Gegebenheiten seiner Hand, mit welcher er die Anzeigeeinrichtung bedienen möchte, eingestellt ist. Beispielsweise kann die Anzeigevorrichtung in einem Einstellmodus betrieben werden, in welchem ein Fahrzeuginsasse die Neigung der Anzeigeeinrichtung manuell - beispielsweise über einen Schalter oder auch über ein angezeigtes Menü der Anzeigeeinrichtung- verändern und dann in einer von ihm gewünschten Gebrauchsposition abspeichern kann. Zusätzlich kann es auch noch vorgesehen sein, dass neben der personalisierten Neigung der Anzeigeeinrichtung noch weitere personalisierte Einstellungen, wie beispielsweise eine Doppel-Klick-Geschwindigkeit oder auch eine Zoom-Geschwindigkeit und dergleichen, mit der Personenerkennung übernommen werden. Im Wesentlichen können alle denkbaren, personalisierbaren Einstellungen an der Anzeigeeinrichtung mit der Personenerkennung gekoppelt werden.

Weitere Vorteile, Merkmale und Einzelheiten der Erfindung ergeben sich aus der nachfolgenden Beschreibung bevorzugter Ausführungsbeispiele sowie anhand der Zeichnungen. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Zeichnung zeigt in:
- Fig. 1: eine Perspektivansicht auf einen teilweise dargestellten Mitteltunnel eines Kraftwagens, wobei vor einem Gangwahlhebel des Kraftwagens eine flexible Anzeigeeinrichtung in ihrer eben in dem Mitteltunnel versenkten Verstauposition dargestellt ist;
- Fig. 2: eine weitere Perspektivansicht auf den Mitteltunnel des Kraftwagens, wobei die flexible Anzeigeeinrichtung in einer nach oben gebogenen Gebrauchsposition gezeigt ist;
- Fig. 3: eine schematische Seitenansicht, in welcher der Gangwahlhebel und die in ihre Gebrauchsposition nach oben gebogene Anzeigeeinrichtung gezeigt sind;
- Fig. 4: eine Seitenschnittansicht, in welcher ein mehrlagiger Aufbau der flexiblen Anzeigeeinrichtung sowie ein Hebel einer Verstelleinrichtung in der abgesenkten Verstauposition dargestellt sind;
- Fig. 5: eine schematische Seitenschnittansicht eines Ausschnitts der flexiblen Anzeigeeinrichtung, wobei die unterschiedlichen Schichten der flexiblen Anzeigeeinrichtung dargestellt sind, wenn die Anzeigeeinrichtung in ihrer Verstauposition angeordnet ist;
- Fig. 6: eine weitere schematische Seitenschnittansicht, in welcher die Anzeigeeinrichtung in ihrer nach oben gebogenen Gebrauchsposition sowie der dann entsprechend aufgestellte Hebel dargestellt sind;
- Fig. 7: eine Seitenschnittansicht, in welcher die unterschiedlichen Schichten der Anzeigeeinrichtung dargestellt sind, wobei deren Anordnung im in die Gebrauchsposition hochgebogenem Zustand der Anzeigeeinrichtung dargestellt ist;
- Fig. 8: eine schematische Darstellung eines freien Endbereichs der mehrschichtigen Anzeigeeinrichtung, wobei eine Klemmeinrichtung im Detail gezeigt ist, mittels welcher die einzelnen Schichten der Anzeigeeinrichtung miteinander verbunden sind;
- Fig. 9a: eine perspektivische Rückansicht der in ihre Gebrauchsposition nach oben gebogenen Anzeigeeinrichtung;
- Fig. 9b: eine perspektivische Rückansicht einer alternativen Ausführungsform der Anzeigevorrichtung, wobei die Anzeigeeinrichtung wiederum in ihre Gebrauchsposition nach oben gebogen ist;
- Fig. 10: eine weitere schematische Seitenschnittansicht von der in ihrer Verstauposition angeordneten Anzeigeeinrichtung, wobei im vorliegenden Fall der Hebel zum Hochbiegen der Anzeigeeinrichtung V-förmig ausgebildet ist;
- Fig. 11a: eine weitere schematische Seitenschnittansicht der in Fig. 10 gezeigten Anordnung, wobei die Anzeigeeinrichtung in ihrer nach oben gebogenen Gebrauchsposition gezeigt ist;
- Fig. 11b: eine weitere schematische Seitenschnittansicht von der in ihrer Gebrauchsposition angeordneten Anzeigeeinrichtung, wobei im vorliegenden Fall eine als Deckel ausgebildete Abdeckung vorgesehen ist, mittels welchem eine durch das Verschwenken der Anzeigeeinrichtung freigelegte Öffnung verdeckt wird; und in
- Fig. 12: eine perspektivische Rückansicht der in ihre Gebrauchsposition hochgebogenen Anzeigeeinrichtung, wobei zwei Hebel an der Anzeigeeinrichtung angeordnet sind, mittels welchen die Anzeigeeinrichtung zwischen der Verstauposition und der Gebrauchsposition hin und her gebogen werden kann.

In den Figuren werden gleiche oder funktionsgleiche Elemente mit gleichen Bezugszeichen versehen.

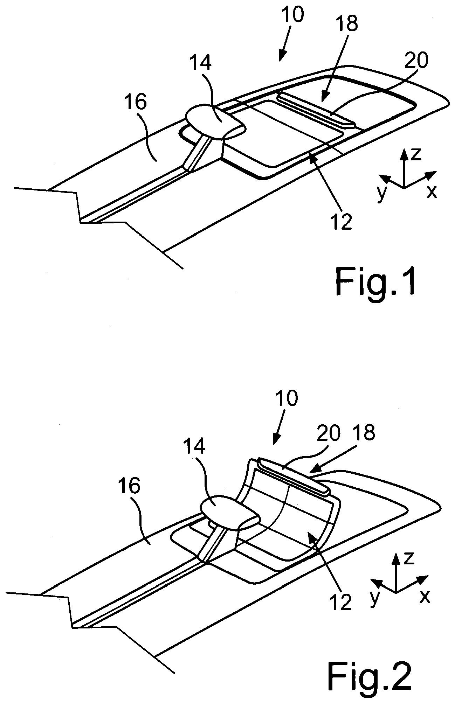

Eine insgesamt mit 10 bezeichnete Anzeigevorrichtung für einen Kraftwagen ist in einer schematischen Perspektivansicht in Fig. 1 gezeigt. Die Anzeigevorrichtung 10 umfasst eine flexible Anzeigeeinrichtung 12, welche in Fahrzeuglängsrichtung x vor einem Gangwahlhebel 14 an einem Mitteltunnel 16 eines nicht näher bezeichneten Kraftwagens angeordnet ist. Die Anzeigevorrichtung 10 umfasst eine in dem Mitteltunnel 16 ausgebildete, hier nicht näher bezeichnete Vertiefung, in welcher die Anzeigeeinrichtung 12 in der vorliegend gezeigten Verstauposition eben angeordnet ist. Die Oberseite der Anzeigeeinrichtung 12 ist in der Verstauposition im Wesentlichen bündig abschließend mit dem Mitteltunnel 16 angeordnet. An einem freien Endbereich 18 der Anzeigeeinrichtung 12 ist eine Klemmeinrichtung 20 angebracht, wobei die Klemmeinrichtung 20 dazu dient, mehrere, hier nicht gezeigte Schichten der Anzeigeeinrichtung 12 miteinander zu verbinden bzw. diese zusammenzuhalten. Auf die Klemmeinrichtung 20 und deren Aufbau wird im Zusammenhang mit den noch nachfolgenden Figuren näher eingegangen werden.

In Fig. 2 ist die Anzeigevorrichtung 10 in einer weiteren perspektivischen Ansicht gezeigt. Im vorliegend gezeigten Fall ist die Anzeigeeinrichtung 12 in einer in Fahrzeughochrichtung z nach oben gebogenen Gebrauchsposition gezeigt. Die Anzeigevorrichtung 10 umfasst dafür eine nicht dargestellte Verstelleinrichtung, welche dazu ausgebildet ist, die Anzeigeeinrichtung 12 von der in der Fig. 1 gezeigten Verstauposition in die in Fig. 2 gezeigte Gebrauchsposition nach oben zu biegen. Vorzugsweise wird die Anzeigeeinrichtung 12 von der in der Fig. 1 gezeigten Verstauposition in die in Fig. 2 gezeigte Gebrauchsposition gebogen, sobald eine Zündung des Kraftwagens aktiviert worden ist, also ein Zustand Klemme 15 ein vorliegt. Gleichzeitig mit dem Hochbiegen der Anzeigeeinrichtung 12 in die Gebrauchsposition wird die Anzeigeeinrichtung 12 zum Anzeigen von unterschiedlichsten Inhalten, beispielsweise einer graphischen Benutzeroberfläche, aktiviert. Sobald die Zündung des Kraftwagens wieder deaktiviert wird, also ein Zustand Klemme 15 aus herrscht, wird die Anzeigeeinrichtung 12 wiederum automatisch von der in Fig. 2 gezeigten Gebrauchsposition in die in Fig. 1 gezeigte Verstauposition zurückgebogen.

Zusätzlich kann es vorgesehen sein, dass die Anzeigevorrichtung 10 ein hier nicht dargestelltes Bedienelement, beispielsweise in Form einer Taste, umfasst, mittels welchem ein Fahrer ein Hochbiegen der Anzeigeeinrichtung 12 in die Gebrauchsposition und wiederum ein Herunterbiegen der Anzeigeeinrichtung 12 in die Verstauposition bewirken kann. Zusätzlich kann es auch vorgesehen sein, dass ein Fahrzeuginsasse die Verstellung der Anzeigeeinrichtung 12 von der Verstauposition in die Gebrauchsposition und wieder zurück durch entsprechend vorgegebene Multi-Touch-Gestenbedienungen an der Anzeigeeinrichtung 12 bewirken kann.

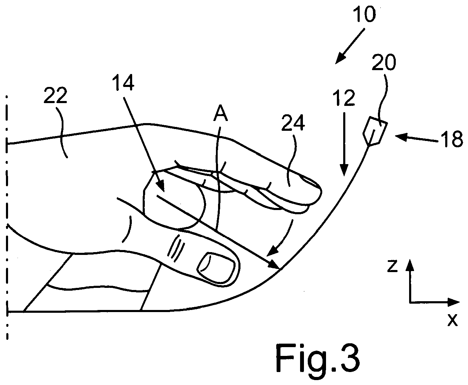

In Fig. 3 ist die in die Verstauposition hochgebogene Anzeigeeinrichtung 12 in einer schematischen Seitenansicht gezeigt. Wie zu erkennen, dient der Gangwahlhebel 14, bei welchem es sich beispielsweise um einen sogenannten Shift-By-Wire-Hebel handeln kann, als Ablage für eine Hand 22 eines Fahrzeuginsassen, so dass er beispielsweise mit seinem Zeigefinger 24 die in die Gebrauchsposition hochgebogene Anzeigeeinrichtung 12 bequem bedienen kann. Dadurch, dass die Anzeigeeinrichtung 12 in der Gebrauchsposition bogenförmig in Fahrzeughochrichtung z nach oben und in Richtung der Hand 22 bzw. in Richtung des Gangwahlhebels 14 - also in Fahrzeuglängsrichtung x - gewölbt ist, ergibt sich ein im Wesentlichen konstanter Abstand A zwischen dem Gangwahlhebel 14 und der Anzeigeeinrichtung 12. Folglich ist beispielsweise auch der Zeigefinger 24 im Wesentlichen gleich weit von allen Punkten der nach oben gewölbten Anzeigeeinrichtung 12 entfernt, so dass ein Fahrzeuginsasse mit seinem Zeigefinger 24 ohne seine Hand 22 weiter bewegen zu müssen die Anzeigeeinrichtung 12 berühren kann. Im vorliegenden Fall ist dies besonders vorteilhaft, da es sich bei der Anzeigeeinrichtung 12 um einen sogenannten Touchscreen handelt. Mit anderen Worten kann ein Fahrzeuginsasse durch Berührung der Anzeigeeinrichtung 12 unterschiedlichste Funktionen des Kraftwagens steuern.

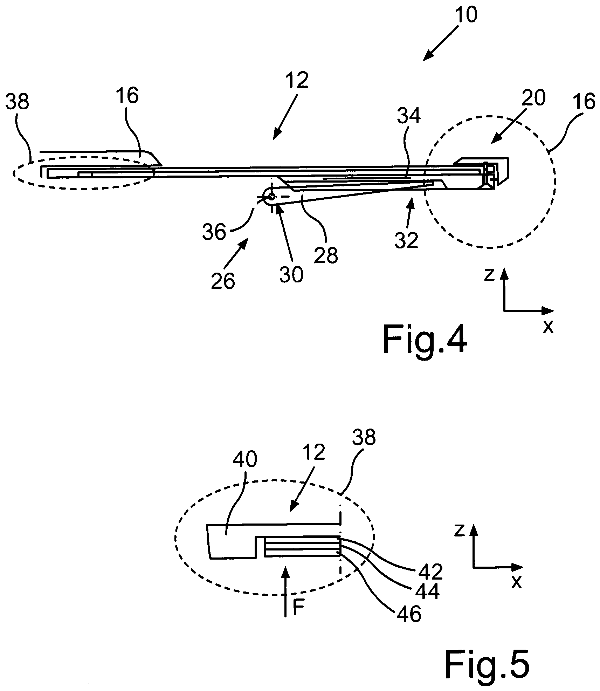

In Fig. 4 ist die Anzeigevorrichtung 10 in einer schematischen Seitenansicht gezeigt, wobei eine nicht näher bezeichnete Verstelleinrichtung einen verschwenkbaren Hebelmechanismus 26 aufweist. Die Anzeigeeinrichtung 12 ist im vorliegenden Fall wiederum in ihrer abgesenkten Verstauposition gezeigt. Der verschwenkbare Hebelmechanismus 26 umfasst in der vorliegenden Ausführungsform einen einzigen Hebel 28, welcher mit einem Endbereich 30 an einem von der Anzeigeeinrichtung 12 verschiedenen, hier nicht dargestellten Bauteil der Anzeigevorrichtung10 verschwenkbar gelagert und mit einem gegenüberliegenden Endbereich 32 an einer an der Anzeigeeinrichtung 12 befestigen Linearführung 34 gelagert ist.

Der Hebel 28 kann also um eine in Fahrzeugquerrichtung y verlaufende Drehachse 36 verschwenkt werden, um die Anzeigeeinrichtung 12 von der hier gezeigten Verstauposition in die nach oben gebogene Gebrauchsposition zu bewegen. Beispielsweise umfasst die Verstelleinrichtung dafür einen hier nicht dargestellten Elektromotor, mittels welchem der Hebel 28 um die Drehachse 36 verschwenkbar ist.

Beim Aufbiegen der Anzeigeeinrichtung 12 in die Gebrauchsposition wird der Endbereich 32 in der Linearführung 34 geführt, wobei der Endbereich 32 sich relativ zur Anzeigeeinrichtung 12 bewegen kann und dabei aber stets in Kontakt mit der Anzeigeeinrichtung 12, genauer mit der Linearführung 34, bleibt.

In Fig. 4 ist zudem der Endbereich 38, in welchem die Klemmeinrichtung 20 angeordnet ist, hervorgehoben. Des Weiteren ist ein weiterer, in der vorliegenden Darstellung links angeordneter Endbereich 38 der Anzeigeeinrichtung 12 gekennzeichnet, welcher unterhalb eines nicht näher bezeichneten Vorsprungs des Mitteltunnels 16 angeordnet ist.

In Fig. 5 ist der unter dem nicht näher bezeichneten Vorsprung des Mitteltunnels 16 angeordnete Endbereich 18 in einer vergrößerten Darstellung gezeigt. Wie zu erkennen, weist die Anzeigeeinrichtung 12 einen mehrschichtigen Aufbau auf. Die oberste Schicht ist eine transparente Deckschicht 40, wobei unter dieser transparenten Deckschicht 40 eine transparente berührungssensitive Sensorschicht 42 und darunter eine organische Leuchtdioden umfassende Anzeigeschicht 44 angeordnet ist. Unterhalb der Anzeigeschicht 44 ist noch eine Trägerschicht 46 angeordnet, welche eine in Richtung der Deckschicht 40 gerichtete Kraft F auf die Anzeigeschicht 44 ausübt. Der Vorsprung des Mittelstunnels 16 fixiert diesen mehrschichtigen Aufbau zwar in Fahrzeughochrichtung z, klemmt den Schichtaufbau jedoch dabei nur so stark ein, dass eine translatorische Relativbewegung zwischen den einzelnen Schichten 40, 42, 44 und/oder 46 noch möglich ist.

Die Schichten 40, 42, 44 und/oder 46 können dabei mit einer antistatischen Beschichtung versehen sein. Dadurch wird bei einer translatorischen Relativbewegung zwischen den Schichten 40, 42, 44 und/oder 46 eine elektrostatische Aufladung der Schichten 40, 42, 44 und/oder 46 verhindert. Ferner weist die Deckschicht 40 eine Anti-Reflexionsbeschichtung auf. Zusätzlich können aber auch einige der darunter liegenden Schichten 42, 44, 46 ebenfalls eine Anti-Reflexionsbeschichtung aufweisen. Dies trägt zur verbesserten Ablesbarkeit und zu einer verbesserten optischen Anmutung der Anzeigeeinrichtung 12 bei.

Die transparente Deckschicht 40 ist in dem Endbereich 38 der Anzeigeeinrichtung 12 an einem von der Anzeigeeinrichtung 12 verschiedenen, hier nicht dargestellten Bauteil befestigt. Die restlichen Schichten 42, 44, 46 der Anzeigeeinrichtung 12 sind in der vorliegenden Anordnung im Endbereich 38 in Fahrzeuglängsrichtung x relativbeweglich zueinander und auch relativbeweglich bezüglich der Deckschicht 40. Wie in Fig. 4 zu erkennen, sind sämtliche Schichten 40, 42, 44, 46 sowie zusätzlich noch die Linearführung 34 in dem freien Endbereich 18 mittels der Klemmeinrichtung 20 miteinander verbunden. Mit anderen Worten ist der schichtweise Aufbau der Anzeigeeinrichtung 12 lediglich an dem freien Endbereich 18 derart fixiert, dass die einzelnen Schichten 40, 42, 44, 46 sowie die Linearführung 34 sich nicht translatorisch relativ zueinander bewegen können. In dem Endbereich 38 hingegen ist lediglich die transparente Deckschicht 40 derart festgelegt, dass die restlichen darunter angeordneten Schichten 42, 44, 46 sich translatorisch relativ zu der Deckschicht 40 bewegen können.

In Kombination mit der berührungssensitiven Sensorschicht 42 und der die organischen Leuchtdioden aufweisenden Anzeigeschicht 44 ist die Anzeigeeinrichtung 12 also als Touchscreen ausgebildet. Die Sensorschicht 42 kann beispielsweise als kapazitive Sensorschicht ausgebildet sein, so dass Berührungen der transparenten Deckschicht 42, beispielsweise mit dem Zeigefinger 24 wie in Fig. 3 gezeigt - erfasst und in entsprechende Steuerbefehle zum Betreiben unterschiedlichster Funktionseinheiten des Kraftwagens umgesetzt werden können.

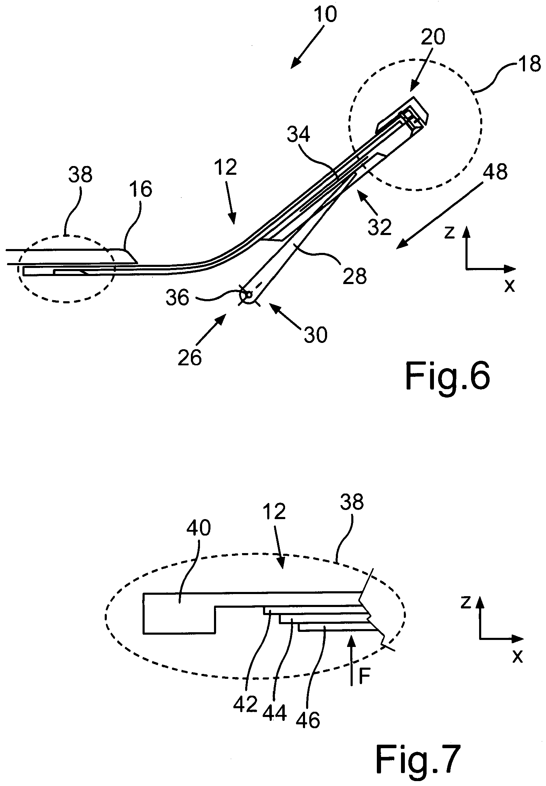

In Fig. 6 ist die Anzeigevorrichtung 10 wiederum in einer schematischen Seitenschnittansicht gezeigt, wobei die Anzeigeeinrichtung 12 nun in ihrer nach oben gebogenen Gebrauchsposition dargestellt ist. Die zuvor bereits erwähnte Linearführung 34 dient gleichzeitig auch als Stützelement für die Anzeigeeinrichtung 12. Beispielsweise kann die Linearführung einen plattenförmig ausgebildeten Teil aufweisen, der sich im Wesentlichen über die gesamte Höhe und Breite des Teils der Anzeigeeinrichtung 12 erstreckt, der in der nach oben gebogenen Gebrauchsstellung freistehend ist. Bei einer Druckbeaufschlagung der als Touchscreen ausgebildeten Anzeigeeinrichtung 12 wird diese dann durch die Linearführung stabil abgestützt, in der vorliegenden Darstellung v.a. in Fahrzeuglängsrichtung x.

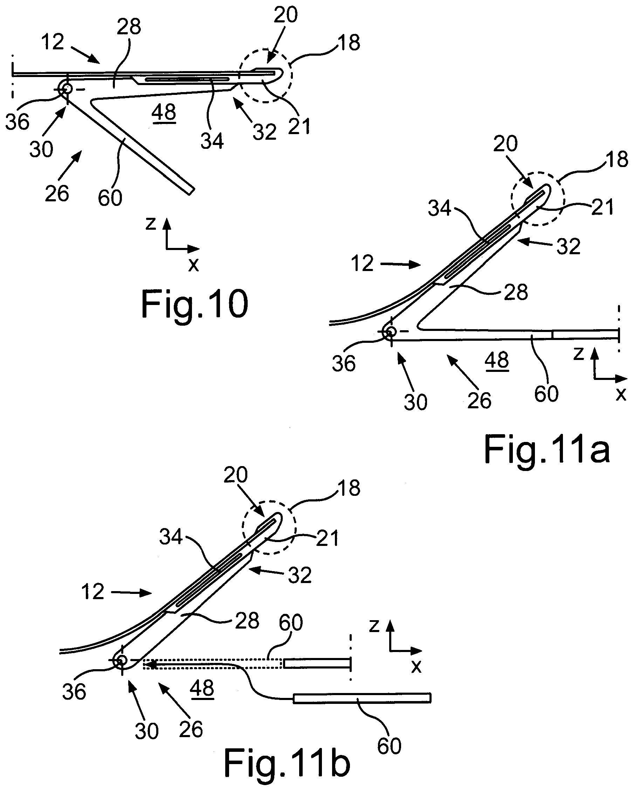

Die Anzeigevorrichtung 10 kann eine hier nicht dargestellte Abdeckung aufweisen, welche in der in Fig. 6 gezeigten Gebrauchsposition der Anzeigeeinrichtung 12 eine Öffnung 48 verdeckt, die durch Verschwenken der Anzeigeeinrichtung 12 von der Verstauposition in die hier gezeigte Gebrauchsposition entsteht. Auf die Abdeckung wird im Nachfolgenden unter Bezugnahme auf die Figuren 10, 11a und 11b noch näher eingegangen werden. Zunächst wird jedoch auf das Verhalten der einzelnen Schichten 40, 42, 44, 46 beim Hochbiegen der Anzeigeeinrichtung 12 in die Gebrauchsposition eingegangen.

In Fig. 7 ist wiederum der Endbereich 38, welcher unterhalb des Vorsprungs des Mitteltunnels 16 angeordnet ist, in einer vergrößerten schematischen Seitenansicht gezeigt. Wie zu erkennen, haben sich die einzelnen Schichten 40, 42, 44, 46 aufgrund des Hochbiegens der Anzeigeeinrichtung 12 in die Gebrauchsposition relativ zueinander verschoben. Im vorliegenden Fall sind die Schichten 40, 42, 44, 46 in dem Endbereich 38 nicht miteinander verbunden, beispielsweise miteinander verklebt, so dass eine Relativbewegung zwischen allen Schichten 40, 42, 44, 46 beim Hochbiegen der Anzeigeeinrichtung 12 in die Gebrauchsposition ermöglicht wird. Dies bringt den Vorteil mit sich, dass keine unerwünschten und gegebenenfalls für die einzelnen Schichten 40, 42, 44, 46 schädlichen Spannungen auftreten. Alternativ kann es beispielsweise auch vorgesehen sein, dass die Sensorschicht 42 und die Anzeigeschicht 44 beispielsweise miteinander verklebt sind, wobei der aus den beiden Schichten 42, 44 gebildete Schichtverbund in diesem Fall nach wie vor zumindest noch relativbeweglich zur transparenten Deckschicht 40 und zu der Trägerschicht 46 ist.

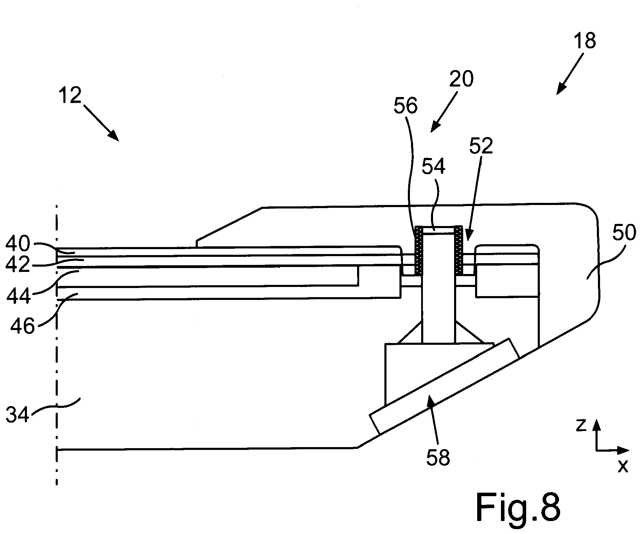

In Fig. 8 ist der in den Figuren 4 und 6 gekennzeichnete freie Endbereich 18 in einer vergrößerten Seitenschnittansicht gezeigt. Die Klemmeinrichtung 20 umfasst ein Klemmelement 50, eine Mehrzahl von Bohrungen 52 sowie eine Mehrzahl von Schrauben 54. Die einzelnen Schichten 40, 42, 44, 46 sowie die Linearführung 34 sind in Querrichtung y mit einer Mehrzahl der Bohrungen 52 durchsetzt, wobei in den jeweiligen Bohrungen 52 jeweilige Schrauben 54 eingeführt sind. Das Klemmelement 50 weist an den jeweiligen Bohrungen 52 jeweilige Innengewinde 56 auf, in welche die Schrauben 54 eingeschraubt sind. Durch die Klemmeinrichtung 20 werden also die einzelnen Schichten 40, 42, 44, 46 sowie die Linearführung 34 fest miteinander verbunden, so dass in dem freien Endbereich 18 der Anzeigeeinrichtung 12 keine Relativbewegung zwischen den einzelnen Komponenten der Anzeigeeinrichtung 12 ermöglicht wird. Die Klemmeinrichtung 20 kann darüber hinaus noch einen Deckel 58 aufweisen, mittels welchem die jeweiligen Schrauben 54 verdeckt werden.

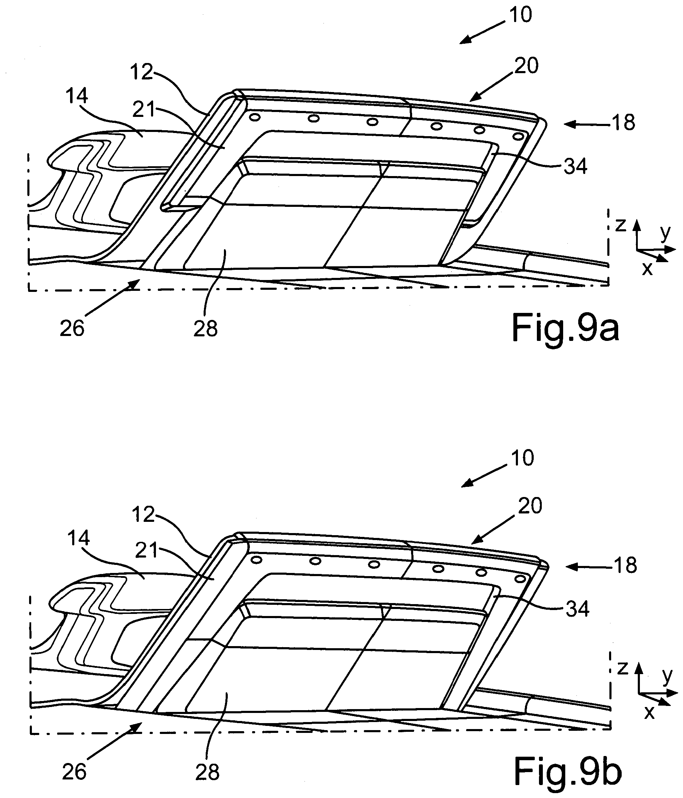

In Fig. 9a ist die Anzeigevorrichtung 10 in einer perspektivischen Rückansicht gezeigt, wobei die Anzeigeeinrichtung 12 in ihrer nach oben gebogenen Gebrauchsposition gezeigt ist. Wie zu erkennen, erstreckt sich der Hebel 28 des Hebelmechanismus 26 fast über die gesamte Breite der Anzeigeeinrichtung 12, wobei die Linearführung 34 in Form eines einseitig offenen Rahmens ausgebildet ist, in welchem der Hebel 28 geführt ist. Aufgrund der Breite des Hebels 28 wird die Anzeigeeinrichtung 12 zum einen besonders sicher in der Gebrauchsposition abgestützt und zum anderen beim nach oben Biegen der Anzeigeeinrichtung 12 in einem relativ großen Flächenbereich im Wesentlichen gleichmäßig mit einer Aufstellkraft beaufschlagt. In der vorliegend gezeigten Ausführungsform ragt die Anzeigeeinrichtung 12 seitlich - also in Fahrzeugquerrichtung y - aus der Klemmeinrichtung 20 heraus. Mit anderen Worten ist der laminare Schichtaufbau der Anzeigeeinrichtung 12 seitlich nicht durch die Klemmeinrichtung 20 begrenzt.

In Fig. 9b ist eine alternative Ausführungsform der Anzeigevorrichtung 10 gezeigt. Um einen besonders robusten Aufbau der Anzeigeeinrichtung 12 zu ermöglichen, ist es in der hier dargestellten Ausführungsform vorgesehen, dass die Klemmeinrichtung 20 die Anzeigeeinrichtung 12 seitlich umgibt, also wie ein Rahmen umschließt. Entsprechende seitliche Schenkel 21 der Klemmeinrichtung 20 umschließen die seitlichen Randbereiche der Anzeigeeinrichtung 12 zumindest über einen gewissen Bereich.

In Fig. 10 ist die Anzeigeeinrichtung 12 ausschnittsweise in ihrer nach unten geklappten Verstauposition gezeigt. Im vorliegend gezeigten Ausführungsbeispiel ist der Hebelmechanismus 26 im Wesentlichen V-förmig ausgebildet, wobei der Hebelmechanismus 26 neben dem Hebel 28, welcher zum Verstellen der Anzeigeeinrichtung 12 dient, noch einen als Abdeckung 60 dienenden weiteren Schenkel bzw. Hebel aufweist. Wird der Hebel 28 nun gegen den Uhrzeigersinn verschwenkt, um die Anzeigeeinrichtung 12 von der in Fig. 10 gezeigten Verstauposition in die nach oben gebogene Gebrauchsposition zu biegen, wird der als die Abdeckung 60 dienende Schenkel bzw. Hebel ebenfalls gegen den Uhrzeigersinn mitverschwenkt.

In Fig. 11a ist die in die Gebrauchsposition gebogene Anzeigeeinrichtung 12 wiederum in einer schematischen Seitenansicht gezeigt. Dadurch, dass der Hebelmechanismus 26 V-förmig ausgebildet ist, also neben dem Hebel 28 noch die Abdeckung 60 aufweist, wird die Öffnung 48 unterhalb der nach oben gebogenen Anzeigeeinrichtung 12 durch die Abdeckung 60 verschlossen, wobei die Abdeckung 60 vorzugsweise bündig mit dem Mitteltunnel 16 abschließt. Zum einen kann dadurch sichergestellt werden, dass keine Objekte, insbesondere kein Schmutz, in die Öffnung 48 gelangen, wenn die Anzeigeeinrichtung 12 in ihre Gebrauchsposition nach oben gebogen worden ist. Zum anderen verbessert dies auch das optische Erscheinungsbild der gesamten Anzeigevorrichtung 10, da kein Blick in die Öffnung 48 geworfen werden kann.

In Fig. 11b ist die in die Gebrauchsposition gebogene Anzeigeeinrichtung 12 wiederum in einer schematischen Seitenansicht gezeigt. Im vorliegend gezeigten Ausführungsbeispiel wird die Abdeckung 60 durch eine deckelförmige Abdeckung realisiert. Beim Verschwenken der Anzeigeeinrichtung 12 von der versenkten Verstauposition in die hier gezeigte Gebrauchsposition wird die Abdeckung in Fahrzeuglängsrichtung x verschoben, sodass die sich auftuende Öffnung 48 dadurch verdeckt wird. Die deckelartig ausgebildete Abdeckung kann während die Anzeigeeinrichtung 12 in ihrer abgesenkten Verstauposition angeordnet ist unterhalb einer Teilbereichs des Mitteltunnels 16 für die Fahrzeuginsassen unsichtbar versenkt angeordnet sein. Der Vorteil der in Fig. 11b gezeigten Ausführung der Abdeckung 60 gegenüber der in den Fig. 10 und 11a gezeigten Ausführung der Abdeckung 60 besteht darin, dass die Öffnung 48 besonders schnell verschlossen bzw. abgedeckt werden kann. Die in Fig. 11b gezeigte Abdeckung 60 kann synchron mit der Bewegung des Hebels 28 so bewegt werden, dass die Öffnung 48 möglichst schnell verschlossen wird.

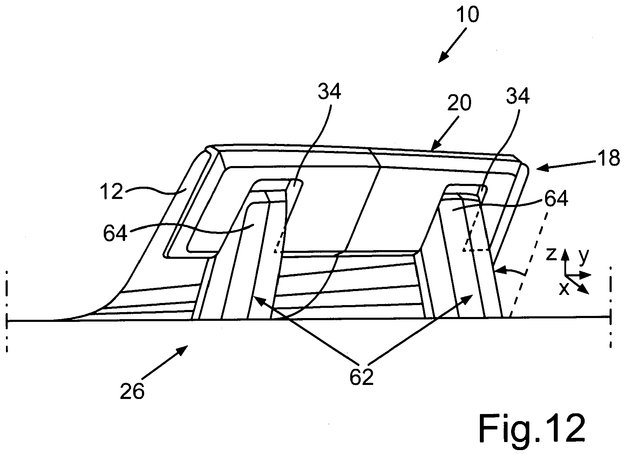

In Fig. 12 ist eine alternative Ausführungsform der Anzeigevorrichtung 10 in einer perspektivischen Rückansicht gezeigt, wobei die Anzeigeeinrichtung 12 in ihrer nach oben gebogenen Gebrauchsposition gezeigt ist. Der Hebelmechanismus 26 weist in der vorliegenden Ausführungsform der Anzeigevorrichtung 10 zwei Hebel 62 auf, welche mit jeweiligen hier nicht zu erkennenden Endbereichen an zumindest einem von der Anzeigeeinrichtung 12 verschiedenen Bauteil der Anzeigevorrichtung 10 verschwenkbar gelagert und mit jeweiligen gegenüberliegenden Endbereichen 64 an jeweiligen an der Anzeigeeinrichtung 12 befestigen Linearführungen 34 gelagert sind.

Dadurch, dass zwei Hebel 62 vorgesehen sind, kann nicht nur die Neigung der Anzeigeeinrichtung 12 in Fahrzeughochrichtung z beeinflusst werden. Durch eine unterschiedliche Ansteuerung bzw. Verschwenkung der Hebel 62 ist es zudem möglich, die Anzeigeeinrichtung 12 in der Gebrauchsposition zusätzlich entweder in Richtung eines Fahrers oder eines Beifahrers zu neigen. Beispielsweise kann mittels der Sensorschicht 44 erfasst werden, ob ein Fahrer oder ein Beifahrer seine Hand bzw. einen Finger an die Anzeigeeinrichtung 12 annähert. Wird beispielsweise erfasst, dass der Fahrer seinen Finger an die Anzeigeeinrichtung 12 annähert, werden die beiden Hebel 62 derart angesteuert und verschwenkt, dass die Anzeigeeinrichtung 12 in Richtung des Fahrers geneigt wird. Umgekehrt ist es genauso möglich, dass sobald erfasst wird, dass ein Beifahrer beispielsweise seinen Finger an die Anzeigeeinrichtung 12 annähert, die Hebel 62 wiederum derart angesteuert und verschwenkt werden, dass die Anzeigeeinrichtung 12 in Richtung des Beifahrers geneigt wird. Zum Erkennen, ob ein Fahrer oder ein Beifahrer gerade mit der Anzeigeeinrichtung 12 interagieren bzw. diese bedienen möchte, kann es zusätzlich auch beispielsweise vorgesehen sein, dass in dem Kraftwagen ein Kamerasystem integriert ist, welches dazu ausgebildet ist, zu erfassen, ob gerade ein Fahrer oder ein Beifahrer einen seiner Finger in Richtung der Anzeigeeinheit 12 ausstreckt. Für den Fall, dass weder der Fahrer noch der Beifahrer gerade die Anzeigeeinrichtung 12 bedienen wollen, kann es vorgesehen sein, dass die Hebel 62 wiederum derart angesteuert werden, dass die Anzeigeeinrichtung 12 lediglich nach oben in ihre Gebrauchsposition verschwenkt wird, wobei die Anzeigeeinrichtung 12 in der Gebrauchsposition eine Art Neutrallage einnimmt, in welcher die Anzeigeeinrichtung 12 weder zum Fahrer noch zum Beifahrer geneigt ist.

In den vorliegend erläuterten Ausführungsbeispielen wurde bislang nur auf den Fall eingegangen, dass die Anzeigevorrichtung 10 im Bereich eines Mitteltunnels 16 in der vorderen Sitzreihe eines Kraftwagens angeordnet ist. Im Wesentlichen kann die Anzeigevorrichtung 10 an beliebigen Positionen im Fahrzeuginnenraum angeordnet werden, beispielsweise an einer Mittelkonsole, einer Instrumententafel oder auch beispielsweise im Fondbereich eines Kraftwagens, beispielsweise als Anzeigeeinrichtung für ein Rear-Seat-Entertainment-System.

Dadurch, dass die Anzeigeeinrichtung 12 bei Bedarf in die Gebrauchsposition gebogen werden kann, wird eine besonders gute ergonomische Bedienung der Anzeigeeinrichtung 12 ermöglicht. Insbesondere bei einer als Touchscreen ausgebildeten Anzeigeeinrichtung 12 wird durch die erläuterte Anzeigevorrichtung 10 eine besonders stabile Abstützung der Anzeigeeinrichtung 12 in der Gebrauchsposition ermöglicht.

## Patentansprüche

1. Anzeigevorrichtung (10) für einen Kraftwagen, mit
- einer flexiblen Anzeigeeinrichtung (12);
- einer Verstelleinrichtung, welche dazu ausgebildet ist, die Anzeigeeinrichtung (12) von einer Verstauposition in eine Gebrauchsposition zu bewegen;
wobei die Verstelleinrichtung dazu ausgebildet ist, die Anzeigeeinrichtung (12) von der Verstauposition in die Gebrauchsposition zu biegen, **dadurch gekennzeichnet, dass**
die Anzeigeeinrichtung (12) mehrere übereinander angeordnete Schichten (40, 42, 44, 46) aufweist,
wobei ausschließlich die obere Schicht (40) in einem ersten Endbereich (38) der Anzeigeeinrichtung (12) an einem von der Anzeigeeinrichtung (12) verschiedenen Bauteil befestigt ist und die Schichten (40, 42, 44, 46) der Anzeigeeinrichtung (12) an einem gegenüberliegend von dem ersten Endbereich angeordneten freien Endbereich (18) der Anzeigeeinrichtung (12) mittels einer Klemmeinrichtung (20) miteinander verbunden sind.

2. Anzeigevorrichtung (10) nach Anspruch 1,
**dadurch gekennzeichnet, dass**
die Verstelleinrichtung einen verschwenkbaren Hebelmechanismus (26) aufweist, welcher dazu ausgebildet ist, die Anzeigeeinrichtung (12) von der Verstauposition in die Gebrauchsposition zu biegen.

3. Anzeigevorrichtung (10) nach Anspruch 2,
**dadurch gekennzeichnet, dass**
der Hebelmechanismus (26) zumindest einen Hebel (28) aufweist, welcher mit einem Endbereich (30) an einem von der Anzeigeeinrichtung (12) verschiedenen Bauteil der Anzeigevorrichtung (12) verschwenkbar gelagert und mit einem gegenüberliegenden Endbereich (32) an einer an der Anzeigeeinrichtung (12) befestigten Linearführung (34) gelagert ist.

4. Anzeigevorrichtung (10) nach Anspruch 2,
**dadurch gekennzeichnet, dass**
der Hebelmechanismus (26) zwei Hebel (62) aufweist, welche mit jeweiligen Endbereichen an zumindest einem von der Anzeigeeinrichtung (12) verschiedenen Bauteil der Anzeigevorrichtung (10) verschwenkbar gelagert und mit jeweiligen gegenüberliegenden Endbereichen (64) an jeweiligen an der Anzeigeeinrichtung (12) befestigten Linearführungen (34) gelagert sind.

5. Anzeigevorrichtung (10) nach einem der vorhergehenden Ansprüche, **dadurch gekennzeichnet, dass**
die obere Schicht eine transparente Deckschicht (40) ist, unter welcher eine organische Leuchtdioden aufweisende Anzeigeschicht (44) angeordnet ist.

6. Anzeigevorrichtung (10) nach einem der vorhergehenden Ansprüche , **dadurch gekennzeichnet, dass**
die obere Schicht eine transparente Deckschicht (40) ist, unter welcher eine transparente berührungssensitive Sensorschicht (42) und eine organische Leuchtdioden aufweisende Anzeigeschicht (44) angeordnet ist.

7. Anzeigevorrichtung (10) nach einem der Ansprüche 5 oder 6,
**dadurch gekennzeichnet, dass**
unter der Anzeigeschicht (44) eine Trägerschicht (46) angeordnet ist, welche eine in Richtung der Deckschicht (40) gerichtete Kraft (F) auf die Anzeigeschicht (44) ausübt und bezüglich des ersten Endes (38) zumindest relativbeweglich zu der Deckschicht (40) ist.

8. Anzeigevorrichtung (10) nach einem der vorhergehenden Ansprüche, **dadurch gekennzeichnet, dass**
die Anzeigevorrichtung (10) eine Abdeckung (60) aufweist, welche in der Gebrauchsposition der Anzeigeeinrichtung (12) eine Öffnung (48) verdeckt, die durch Verschwenken der Anzeigeeinrichtung (12) von der Verstauposition in die Gebrauchsposition entsteht.

9. Kraftwagen mit einer Anzeigevorrichtung (10) nach einem der vorhergehenden Ansprüche.

10. Kraftwagen nach Anspruch 9,
**dadurch gekennzeichnet, dass**
die Anzeigeeinrichtung (12) an einem Mitteltunnel (16) des Kraftwagens in Vorwärtsfahrtrichtung (x) vor einem Gangwahlhebel (14) des Kraftwagens angeordnet ist.

11. Verfahren zum Betreiben einer Anzeigevorrichtung (10) eines Kraftwagens, bei welchem eine flexible Anzeigeeinrichtung (12) der Anzeigevorrichtung (10) mittels einer Verstelleinrichtung der Anzeigevorrichtung (10) von einer Verstauposition in eine Gebrauchsposition bewegt wird, wobei die Anzeigeeinrichtung (12) mehrere übereinander angeordnete Schichten (40, 42, 44, 46) aufweist, wobei ausschließlich die obere Schicht (40) in einem ersten Endbereich (38) der Anzeigeeinrichtung (12) an einem von der Anzeigeeinrichtung (12) verschiedenen Bauteil befestigt ist und die Schichten (40, 42, 44, 46) der Anzeigeeinrichtung (12) an einem gegenüberliegend von dem ersten Endbereich angeordneten freien Endbereich (18) der Anzeigeeinrichtung (12) mittels einer Klemmeinrichtung (20) miteinander verbunden sind,
wobei die Anzeigeeinrichtung (12) mittels der Verstelleinrichtung von der Verstauposition in die Gebrauchsposition gebogen wird, wobei sich eine oder mehrere unter der oberen Schicht (40) angeordnete Schichten (42, 44, 46) beim Aufbiegen der Anzeigeeinrichtung (12) von der Verstauposition in die Gebrauchsposition translatorisch bezüglich der oberen Schicht (40) bewegen.

12. Verfahren nach Anspruch 11,
**dadurch gekennzeichnet, dass**
die Anzeigeeinrichtung (12) von der Verstauposition in die Gebrauchsposition gebogen wird, sobald eine Zündung des Kraftwagens aktiviert worden ist.

13. Verfahren nach Anspruch 11 oder 12,
**dadurch gekennzeichnet, dass**
die Anzeigeeinrichtung (12) von der Gebrauchsposition in die Verstauposition gebogen wird, sobald eine Zündung des Kraftwagens deaktiviert worden ist.

14. Verfahren nach einem der Ansprüche 11 bis 13,
**dadurch gekennzeichnet, dass**
die Gebrauchsposition in Abhängigkeit von einer erfassten Personenkennung vorgegebenen wird.

## Claims

1. Display device (10) for a motor vehicle, having
- a flexible display apparatus (12);
- an adjusting apparatus which is configured to move the display apparatus (12) from a stowage position into a use position;
wherein the adjusting apparatus is configured to bend the display apparatus (12) from the stowage position into the use position,
**characterised in that**
the display apparatus (12) has several layers (40, 42, 44, 46) arranged above one another,
wherein exclusively the upper layer (40) is fastened in a first end region (38) of the display apparatus (12) to a component different from the display apparatus (12) and the layers (40, 42, 44, 46) of the display apparatus (12) are mutually connected by means of a clamping apparatus (20) at a free end region (18) of the display apparatus (12) arranged opposite to the first end region.

2. Display device (10) according to claim 1,
**characterised in that**
the adjusting apparatus has a pivotable lever mechanism (26) which is configured to bend the display apparatus (12) from the stowage position into the use position.

3. Display device (10) according to claim 2,
**characterised in that**
the lever mechanism (26) has at least one lever (28) which is pivotably mounted with an end region (30) on a component of the display device (12) which is different from the display apparatus (12), and is mounted with an oppositely-situated end region (32) on a linear guide (34) fastened to the display apparatus (12).

4. Display device (10) according to claim 2,
**characterised in that**
the lever mechanism (26) has two levers (62) which are pivotably mounted with respective end regions on at least one component of the display device (10) which is different from the display apparatus (12), and are mounted with respective oppositely-situated end regions (64) on respective linear guides (34) fastened to the display apparatus (12).

5. Display device (10) according to any of the preceding claims,
**characterised in that**
the upper layer is a transparent cover layer (40) below which is arranged a display layer (44) having organic light diodes.

6. Display device (10) according to any of the preceding claims,
**characterised in that**
the upper layer is a transparent cover layer (40) below which is arranged a transparent touch-sensitive sensor layer (42) and a display layer (44) having organic light diodes.

7. Display device (10) according to any of claims 5 or 6,
**characterised in that**
below the display layer (44) is arranged a carrier layer (46) which exerts a force (F), oriented in the direction of the cover layer (40), on the display layer (44) and is at least mobile relatively to the cover layer (40) with respect to the first end (38).

8. Display device (10) according to any of the preceding claims,
**characterised in that**
the display device (10) has a cover (60) which in the use position of the display apparatus (12) covers an opening (48) which results by means of pivoting the display apparatus (12) from the stowage position into the use position.

9. Motor vehicle having a display device (10) according to any of the preceding claims.

10. Motor vehicle according to claim 9,
**characterised in that**
the display apparatus (12) is arranged on a central tunnel (16) of the motor vehicle in forwards drive direction (x) in front of a gear selection lever (14) of the motor vehicle.

11. Method for operating a display device (10) of a motor vehicle in which a flexible display apparatus (12) of the display device (10) is moved by means of an adjusting apparatus of the display device (10) from a stowage position into a use position, wherein the display apparatus (12) has several layers (40, 42, 44, 46) arranged above one another, wherein exclusively the upper layer (40) is fastened in a first end region (38) of the display apparatus (12) to a component different from the display apparatus (12) and the layers (40, 42, 44, 46) of the display apparatus (12) are mutually connected by means of a clamping apparatus (20) at a free end region (18) of the display apparatus (12) arranged opposite the first end region,
wherein the display apparatus (12) is bent by means of the adjusting apparatus from the stowage position into the use position, wherein one or several layers (42, 44, 46) arranged below the upper layer (40) move in a manner which is translatory with regard to the upper layer (40) from the stowage position into the use position when the display apparatus (12) is bent up.

12. Method according to claim 11,
**characterised in that**
the display apparatus (12) is bent from the stowage position into the use position as soon as an ignition of the motor vehicle has been activated.

13. Method according to claim 11 or 12,
**characterised in that**
the display apparatus (12) is bent from the use position into the stowage position as soon as an ignition of the motor vehicle has been deactivated.

14. Method according to any of claims 11 to 13,
**characterised in that**
the use position is predetermined depending on a detected personal identification.

## Revendications

1. Dispositif d'affichage (10) pour un véhicule automobile, avec
- un appareil d'affichage (12) flexible ;
- un appareil de déplacement conçu pour amener l'appareil d'affichage (12) d'une position de rangement à une position d'utilisation ;
dans lequel l'appareil de déplacement est conçu pour plier l'appareil d'affichage (12) de la position de rangement à la position d'utilisation, **caractérisé en ce que**
l'appareil d'affichage (12) présente plusieurs couches (40, 42, 44, 46) agencées les unes au-dessus des autres,
dans lequel seule la couche supérieure (40) est fixée dans une première région d'extrémité (38) de l'appareil d'affichage (12) à un composant qui est différent de l'appareil d'affichage (12) et les couches (40, 42, 44, 46) de l'appareil d'affichage (12) sont reliées les unes aux autres au moyen d'un appareil de serrage (20) au niveau d'une région d'extrémité (18) libre de l'appareil d'affichage (12) agencée à l'opposé de la première région d'extrémité.

2. Dispositif d'affichage (10) selon la revendication 1,
**caractérisé en ce que**
l'appareil de déplacement présente un mécanisme à levier (26) pivotant conçu pour plier l'appareil d'affichage (12) de la position de rangement à la position d'utilisation.

3. Dispositif d'affichage (10) selon la revendication 2,
**caractérisé en ce que**
le mécanisme à levier (26) présente au moins un levier (28) dont une région d'extrémité (30) est montée pivotante au niveau d'un composant du dispositif d'affichage (12) différent de l'appareil d'affichage (12) et dont une région d'extrémité opposée (32) est montée au niveau d'un guide linéaire (34) fixé à l'appareil d'affichage (12).

4. Dispositif d'affichage (10) selon la revendication 2,
**caractérisé en ce que**
le mécanisme de levier (26) présente deux leviers (62) dont les régions d'extrémité respectives sont montées pivotantes au niveau d'au moins un composant du dispositif d'affichage (10) différent de l'appareil d'affichage (12) et dont les régions d'extrémité (64) opposées respectives sont montées au niveau de guides linéaires (34) respectifs fixés à l'appareil d'affichage (12).

5. Dispositif d'affichage (10) selon l'une quelconque des revendications précédentes, **caractérisé en ce que**
la couche supérieure est une couche de revêtement (40) transparente sous laquelle est agencée une couche d'affichage (44) présentant des diodes électroluminescentes organiques.

6. Dispositif d'affichage (10) selon l'une quelconque des revendications précédentes, **caractérisé en ce que**
la couche supérieure est une couche de revêtement (40) transparente sous laquelle est agencée une couche de détection tactile (42) transparente et une couche d'affichage (44) présentant des diodes électroluminescentes organiques.

7. Dispositif d'affichage (10) selon la revendication 5 ou 6,
**caractérisé en ce que**
une couche de support (46), qui exerce sur la couche d'affichage (44) une force (F) dirigée vers la couche de revêtement (40) et qui est au moins mobile par rapport à la couche de revêtement (40) en ce qui concerne la première extrémité (38), est agencée sous la couche d'affichage (44).

8. Dispositif d'affichage (10) selon l'une quelconque des revendications précédentes, **caractérisé en ce que**
le dispositif d'affichage (10) présente un masquage (60) qui, lorsque l'appareil d'affichage (12) se trouve en position d'utilisation, occulte une ouverture (48) créée par le pivotement de l'appareil d'affichage (12) de la position de rangement à la position d'utilisation.

9. Véhicule automobile avec un dispositif d'affichage (10) selon l'une quelconque des revendications précédentes.

10. Véhicule automobile selon la revendication 9,
**caractérisé en ce que**
l'appareil d'affichage (12) est agencé devant, dans le sens de marche avant (x), un levier de sélection de vitesse (14) du véhicule automobile au niveau d'une console centrale (16) du véhicule automobile.

11. Procédé de fonctionnement d'un dispositif d'affichage (10) d'un véhicule automobile, dans lequel un appareil d'affichage (12) flexible du dispositif d'affichage (10) est déplacé d'une position de rangement à une position d'utilisation au moyen d'un appareil de déplacement du dispositif d'affichage (10), dans lequel l'appareil d'affichage (12) présente plusieurs couches (40, 42, 44, 46) agencées les unes au-dessus des autres, dans lequel seule la couche supérieure (40) est fixée dans une première région d'extrémité (38) de l'appareil d'affichage (12) à un composant qui est différent de l'appareil d'affichage (12) et les couches (40, 42, 44, 46) de l'appareil d'affichage (12) sont reliées les unes aux autres au moyen d'un appareil de serrage (20) au niveau d'une région d'extrémité (18) libre de l'appareil d'affichage (12) agencée à l'opposé de la première région d'extrémité,
dans lequel l'appareil d'affichage (12) est plié de la position de rangement à la position d'utilisation au moyen de l'appareil de déplacement, dans lequel une ou plusieurs couche(s) (42, 44, 46) agencée(s) sous la couche supérieure (40) se déplacent de manière translatoire par rapport à la couche supérieure (40) de la position de rangement à la position d'utilisation lors du pliage de l'appareil d'affichage (12).

12. Procédé selon la revendication 11,
**caractérisé en ce que**
l'appareil d'affichage (12) est plié de la position de rangement à la position d'utilisation dès que l'allumage du véhicule automobile a été activé.

13. Procédé selon la revendication 11 ou 12,
**caractérisé en ce que**
l'appareil d'affichage (12) est plié de la position d'utilisation à la position de rangement dès que l'allumage du véhicule automobile a été désactivé.

14. Procédé selon l'une quelconque des revendications 11 à 13,
**caractérisé en ce que**
la position d'utilisation est prédéfinie en fonction d'un identifiant de personne détecté.
